(19) Europäisches Patentamt / European Patent Office / Office européen des brevets

(11) **EP 1 684 427 B1**

(12) **FASCICULE DE BREVET EUROPEEN**

(45) Date de publication et mention
de la délivrance du brevet:
**19.07.2017 Bulletin 2017/29**

(51) Int Cl.:
***H03H 11/12*** *(2006.01)*

(21) Numéro de dépôt: **05292596.3**

(22) Date de dépôt: **07.12.2005**

(54) **Autoajustement de cellules RC dans un circuit**

Automatische Anpassung von RC Zellen in einer Schaltung

Autoadjustment of RC cells in a circuit

(84) Etats contractants désignés:
**DE FR GB IT**

(30) Priorité: **14.12.2004 FR 0413286**

(43) Date de publication de la demande:
**26.07.2006 Bulletin 2006/30**

(73) Titulaire: **STMICROELECTRONICS SA**
**92120 Montrouge (FR)**

(72) Inventeur: **Trochut, Severin**
**73200 Gilly sur Isere (FR)**

(74) Mandataire: **Grünecker Patent- und
Rechtsanwälte
PartG mbB
Leopoldstraße 4
80802 München (DE)**

(56) Documents cités:
**EP-A- 1 455 449**     **US-A- 5 187 445**
**US-A- 5 519 265**     **US-A1- 2004 169 565**
**US-B1- 6 737 851**

• **HUGHES J B ET AL: "SELF-TUNED RC-ACTIVE FILTERS FOR VLSI" ELECTRONICS LETTERS, IEE STEVENAGE, GB, vol. 22, no. 19, septembre 1986 (1986-09), pages 993-994, XP001149985 ISSN: 0013-5194**

**Description**

L'invention se rapporte aux circuits mettant en oeuvre des cellules contenant des résistances et des capacités, plus précisément des couples de résistance/condensateur. Plus particulièrement l'invention se rapporte à l'ajustement de constantes de temps de cellules RC dans des circuits intégrés.

Actuellement, de très nombreux circuits électroniques sont réalisés en circuit intégré. Parmi ces circuits électroniques certains utilisent des cellules RC, c'est-à-dire des couples résistance/condensateur, pour réaliser des fonctions de filtrage ou de temporisation, par exemple.

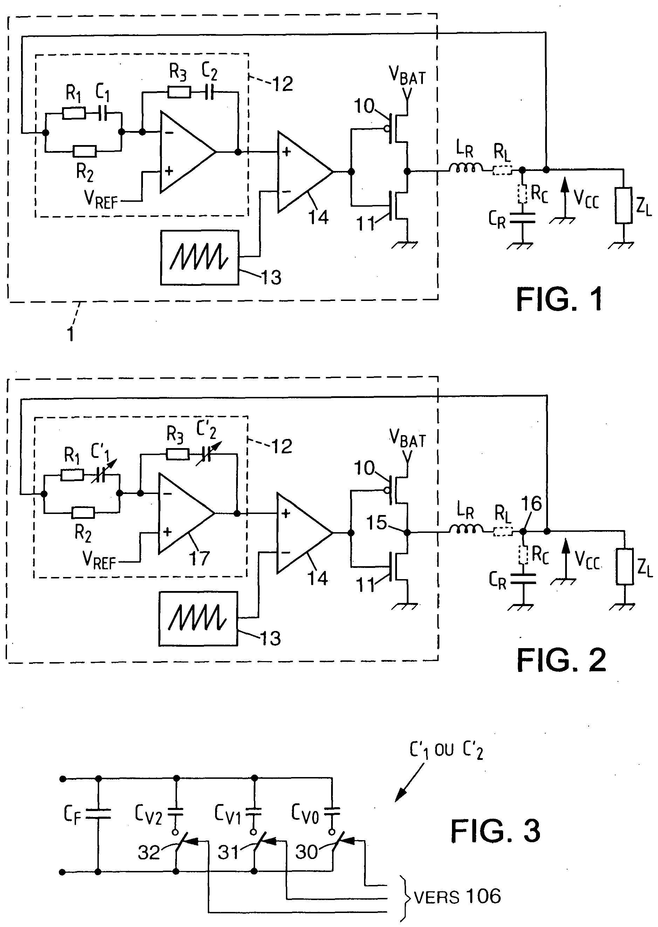

A titre d'exemple, la figure 1 représente un circuit intégré 1 incorporant un convertisseur continu/continu destiné à transformer une tension de batterie $V_{BAT}$ en tension d'alimentation régulée $V_{CC}$ pour alimenter un circuit représenté par l'impédance de charge $Z_L$.

Le principe mis en oeuvre par ce convertisseur continu/continu est connu en lui-même. La tension de batterie est hachée par la paire de transistors 10 et 11 commandée par un signal rectangulaire à rapport cyclique modulé. L'inductance $L_R$ et le condensateur $C_R$ assurent le filtrage de cette tension hachée afin d'avoir une tension d'alimentation $V_{CC}$ continue. Un amplificateur d'erreur 12 amplifie l'erreur entre la tension d'alimentation $V_{CC}$ et une tension de référence $V_{Ref}$. Un générateur de rampe 13 fournit un signal cyclique en forme de rampe. Un comparateur 14 compare l'erreur amplifiée avec le signal cyclique en forme de rampe. Le signal fourni par le comparateur 14 correspond au signal rectangulaire à rapport cyclique variable qui commande la paire de transistors. La modulation du rapport cyclique dépend de l'erreur entre la tension de référence, créant ainsi une boucle de contre réaction qui stabilise la tension d'alimentation $V_{CC}$.

Le convertisseur continu/continu dispose de plusieurs cellules RC. L'amplificateur d'erreur 12 réalise également une fonction de filtrage passe-bas comportant deux pôles et deux zéros afin de stabiliser le bouclage de contre réaction. Toutefois, le bouclage doit permettre d'avoir une bonne réactivité, c'est-à-dire une fréquence de coupure la plus élevée possible afin de compenser rapidement une variation de la tension de batterie $V_{BAT}$ ou de la charge $Z_L$ de manière à assurer une tension d'alimentation $V_{CC}$ continue et constante. Le générateur de rampe 13 peut comporter une ou plusieurs cellules RC. La fréquence et la forme du signal cyclique de rampe dépendent de constante de temps découlant de ces cellules RC.

La précision sur les variations des valeurs de résistance et de capacité des cellules RC dépend d'un cumul de tolérances liées au procédé de fabrication du circuit intégré (notamment défauts d'alignement de masques de fabrication, dispersions sur la concentration de dopants, tolérances d'épaisseur des couches constituant le circuit intégré) et aux conditions de fonctionnement (notamment tension d'alimentation, température). Actuellement, la tolérance sur les valeurs de résistance et de capacité est respectivement de 35% et 20%. Lorsque l'on réalise une cellule RC, les tolérances sur les valeurs se cumulent et la tolérance sur la constante de temps résultante est de 62%.

Pour s'affranchir de ces tolérances, plusieurs techniques sont connues. Une première technique consiste à dimensionner le circuit afin que celui-ci puisse fonctionner dans la situation la plus défavorable. Dans l'exemple du convertisseur continu/continu, cela revient à ralentir la boucle de régulation, c'est-à-dire réduire la bande passante du circuit. Cela entraîne une perte de performance en terme de régulation. La tension d'alimentation $V_{CC}$ mettra plus de temps pour revenir au niveau de $V_{Ref}$.

Une deuxième technique consiste à mettre les composants passifs à l'extérieur du circuit intégré afin que ceux-ci puissent être choisis et/ou mesurés de manière précise pour connaître les valeurs exactes. Cette technique va à l'encontre de l'intégration maximale des circuits. Elle est coûteuse car elle nécessite l'ajout de composant externe. En générale elle n'est utilisée que pour des circuits de haute précision ou lorsque les composants passifs ne peuvent pas être réalisés dans le circuit intégré.

Une troisième technique consiste à rajouter des éléments de compensation qui annulent la dérive des composants. C'est une technique assez bien maîtrisée mais qui ne permet pas d'obtenir simplement une compensation de tous les facteurs d'erreurs. Dans le cas de l'amplificateur d'erreur 12, la compensation des résistances $R_1$, $R_2$ et $R_3$ et des condensateurs $C_1$ et $C_2$ est très complexe à mettre en oeuvre.

Une quatrième technique revient à utiliser des circuits différents qui sont indépendants des variations. Cette technique, dans le cas d'un amplificateur incluant des moyens de filtrage nécessite la réalisation d'un circuit numérique très complexe et très coûteux en terme de taille de silicium.

Et enfin une cinquième technique consiste à ajuster les composants. L'ajustement peut se faire au laser lors de la fabrication pour compenser les erreurs de composant liées au procédé de fabrication. L'ajustement peut être fait dynamiquement à la mise sous tension du circuit ou en cours de fonctionnement. Cela nécessite en général la mesure d'une ou plusieurs caractéristiques d'un circuit, la comparaison des mesures avec des valeurs de référence, puis l'ajustement d'un ou plusieurs composants en fonction de la comparaison. L'ajustement peut se faire en une fois à l'aide de moyens de calcul complexe ou à l'aide d'itérations successives.

La fonction de transfert H(p) de l'amplificateur d'erreur 12 est la suivante :

$$H(p) = \frac{(1 + (R_1 + R_2)C_1 p)(1 + R_3 C_2 p)}{(1 + R_1 C_1 p)R_2 C_2 p}$$

Les erreurs de tolérance sur les résistances $R_1$, $R_2$ et $R_3$ et les condensateurs $C_1$ et $C_2$ éloignent la fonction de transfert H(p) d'une caractéristique idéale. L'ajustement des composants nécessite la réalisation de plusieurs points de mesure pour obtenir une approximation de la fonction de transfert et des moyens de calcul important pour déterminer à partir de la caractéristique mesurée les corrections à apporter aux composants passifs.

Dans US5519265, on note qu'il n'y a que des condensateurs ajustables, mais pas de résistance ajustable.

En résumé, il n'existe pas actuellement de technique pour corriger simplement l'erreur due aux composants sur l'amplificateur d'erreur 12 alors que celui-ci est un amplificateur muni de moyens de filtrage relativement simples.

L'invention propose une solution simple pour corriger les erreurs sur les valeurs des composants des cellules RC dans des circuits intégrés série avec un condensateur de valeur fixe. Le circuit comprend un comparateur qui compare la tension produite sur les noeuds entre la résistance et le condensateur de chacun des deux éléments RC respectivement. Une sortie du comparateur est connectée à l'entrée d'un contrôleur, lequel pilote des interrupteurs qui sont prévus dans le filtre pour ajuster l'étage de filtrage en faisant varier la charge du condensateur de chacun des éléments RC, respectivement.

En résumé, il n'existe pas actuellement de technique pour corriger simplement l'erreur due aux composants sur l'amplificateur d'erreur 12 alors que celui-ci est un amplificateur muni de moyens de filtrage relativement simples.

L'invention propose une solution simple pour corriger les erreurs sur les valeurs des composants des cellules RC dans des circuits intégrés disposant d'au moins deux cellules RC de même nature. Chaque cellule RC dispose d'un composant ayant une valeur ajustable. Des moyens d'étalonnage réalisent l'ajustement d'une cellule RC puis applique la même correction aux composants des autres cellules de même nature.

L'invention est un circuit intégré comportant un premier couple de composants, au moins un deuxième couple de composants et un circuit d'étalonnage. Le premier couple de composants est constitué d'une résistance et d'un condensateur, la résistance étant le composant ajustable du premier couple. Le deuxième couple de composants est constitué d'une résistance de même nature que la résistance du premier couple et d'un condensateur de même nature que le condensateur du premier couple, le condensateur étant le composant ajustable du second couple. Le circuit d'étalonnage produit une valeur d'ajustement du composant ajustable du premier couple afin de compenser l'erreur sur le produit de la résistance par la capacité dudit premier couple, la valeur d'ajustement du composant ajustable du premier couple étant en outre appliquée proportionnellement à la valeur du composant ajustable du deuxième couple par rapport à la valeur du composant ajustable du premier couple. Par composant de même nature il faut comprendre les composants réalisés par les mêmes procédés de fabrication. A titre d'exemple, deux résistances sont de même nature si elles sont réalisées simultanément pendant les mêmes étapes du procédé de fabrication. Elles seront réalisées avec les mêmes matériaux qui auront subi les mêmes erreurs de concentration, les mêmes erreurs d'alignement et les mêmes erreurs d'épaisseur. En outre, ces composants de même nature étant à proximité dans le même circuit, ils subissent un même gradient de variation de valeur et ils sont à la même température. En d'autres termes, des composants de même nature présentent les mêmes dispersions de fabrication ce qui leur confère une même erreur de valeur. L'invention concerne également un procédé d'étalonnage suivant la revendication 9.

L'invention sera mieux comprise et d'autres particularités et avantages apparaîtront à la lecture de la description qui va suivre, la description faisant référence aux dessins annexés parmi lesquels :

- la figure 1 représente un convertisseur continu/continu de l'état de la technique,

- la figure 2 représente le convertisseur continu/continu de la figure 1 modifié selon l'invention,

- la figure 3 montre un exemple de condensateur variable mis en oeuvre dans l'invention,

- la figure 4 montre un exemple de générateur de rampe selon l'invention,

- la figure 5 montre un premier circuit d'étalonnage selon l'invention,

- les figures 6 et 7 illustre l'étalonnage du générateur de rampe à l'aide du premier circuit d'étalonnage,

- la figure 8 montre un deuxième circuit d'étalonnage selon l'invention, et

- la figure 9 illustre l'étalonnage du générateur de rampe à l'aide du deuxième circuit d'étalonnage.

L'invention s'applique à tout type de circuit intégré mettant en oeuvre au moins deux cellules RC nécessitant une précision déterminée. A titre d'exemple, il est décrit, figure 2, un circuit intégré 1 incorporant un convertisseur continu/continu destiné à transformer une tension de batterie $V_{BAT}$ en tension d'alimentation régulée $V_{CC}$ pour alimenter un circuit représenté par une impédance de charge $Z_L$. Cet exemple est donné à titre purement indicatif et non limitatif pour illustrer un mode de réalisation de l'invention.

Le convertisseur continu/continu comporte une paire de transistors 10 et 11, un amplificateur d'erreur 12, un générateur de rampe 13 et un comparateur 14 qui sont inclus dans le circuit intégré 1. Une inductance $L_R$ et un condensateur de filtrage $C_R$ sont placés à l'extérieur du circuit intégré car leurs dimensions ne permettent pas de les réaliser en circuit intégré.

Les transistors 10 et 11 sont par exemple des transistors MOS complémentaires. Les canaux des transistors 10 et 11 sont reliés en série entre un conducteur recevant la tension de batterie $V_{BAT}$ et un conducteur relié à la masse. Le noeud 15 formé par les drains des transistors 10 et 11 constitue une sortie du circuit intégré 1.

Le noeud 15 est relié à une première borne de l'inductance $L_R$. Une deuxième borne de l'inductance $L_R$ est reliée à une première borne du condensateur de filtrage $C_R$ et constitue le noeud 16. Une deuxième borne du condensateur de filtrage $C_R$ est reliée à la masse. Le noeud 16 est relié au circuit à alimenter afin de fournir la tension $V_{CC}$.

Le noeud 16 constitue une entrée du circuit intégré 1. Le noeud 16 est relié à une entrée de l'amplificateur d'erreur 12. Une sortie de l'amplificateur d'erreur 12 est reliée à une première entrée du comparateur 14.

Le générateur de rampe 13 dispose d'une sortie reliée à une deuxième entrée du comparateur 14. Le générateur de rampe 13 fournit sur sa sortie un signal cyclique en forme de rampe.

Le comparateur 14 dispose en outre d'une sortie reliée aux grilles des transistors 10 et 11. Le comparateur 14 fournit un signal dans un premier état lorsque le signal de sortie de l'amplificateur d'erreur 12 est à une tension supérieure à la tension du signal cyclique en forme de rampe, et dans un deuxième état lorsque le signal de sortie de l'amplificateur d'erreur 12 est à une tension inférieure à la tension du signal cyclique en forme de rampe.

Le signal de sortie du comparateur 14 commandant les bases des transistors 10 et 11, ceux-ci effectuent un hachage de la tension de batterie $V_{BAT}$. La tension hachée sur le noeud 15 est filtrée par l'inductance $L_R$ et le condensateur de filtrage $C_R$ afin d'obtenir la tension d'alimentation continue $V_{CC}$.

L'amplificateur d'erreur 12 comporte un amplificateur opérationnel 17 disposant d'une entrée positive, d'une entrée négative et d'une sortie. L'entrée positive reçoit une tension de référence $V_{Ref}$. La tension $V_{Ref}$ est fournie par un générateur de tension de référence non représenté. Le générateur de tension de référence est un circuit utilisant par exemple des jonctions de diodes empilées, et il est compensé pour fournir une référence de tension stable et indépendante de toute variation liée à la fabrication, la température, la tension de batterie ou autre.

L'entrée négative de l'amplificateur opérationnel 17 est reliée à l'entrée de l'amplificateur 12 par l'intermédiaire d'une première branche comportant une résistance $R_1$ et un condensateur $C'_1$ en série, et d'une deuxième branche comportant une résistance $R_2$. L'entrée négative est également reliée à la sortie de l'amplificateur opérationnel 17 qui constitue également la sortie de l'amplificateur d'erreur 12, par l'intermédiaire d'une troisième branche comportant une résistance $R_3$ en série avec un condensateur $C'_2$. La fonction de transfert en signaux variables H(p) de l'amplificateur d'erreur 12 est la suivante :

$$H(p) = \frac{(1+(R_1+R_2)C'_1\,p)(1+R_3C'_2\,p)}{(1+R_1C'_1\,p)R_2C'_2\,p}$$

Le fonctionnement du convertisseur continu/continu est le même que celui de l'état de la technique. L'amplificateur d'erreur 12, le générateur de rampe 13 et le comparateur 14 produisent un signal rectangulaire pour commander les transistors 10 et 11. Le rapport cyclique du signal rectangulaire est asservi sur la tension d'alimentation $V_{CC}$ par l'amplificateur d'erreur 12.

Toutefois, les condensateurs $C'_1$ et $C'_2$ sont des condensateurs ajustables qui sont ajustés selon l'invention à des valeurs qui compensent à la fois l'erreur de valeur des résistances et l'erreur de valeur des condensateurs. Les condensateurs $C'_1$ et $C'_2$ sont par exemple réalisés comme montré sur la figure 3 et ils comportent chacun un condensateur $C_F$ de valeur fixe couplé en parallèle avec des condensateurs $C_{V0}$, $C_{V1}$, $C_{V2}$ par l'intermédiaire d'interrupteurs 30 à 32 respectivement. Les interrupteurs 30 à 32 sont par exemple réalisés avec des transistors MOS.

Sur la figure 3, la partie variable comporte uniquement 3 condensateurs pour simplifier les schémas, il convient d'avoir un nombre plus important de condensateurs pour améliorer la précision de la compensation. Les valeurs des condensateurs $C_{V0}$, $C_{V1}$, $C_{V2}$ correspondent à une décomposition binaire de la partie variable. Si on considère la valeur nominale $C_N$ d'un condensateur $C'_1$ ou $C'_2$, cette valeur nominale peut s'écrire :

$$C_N = C_F + C_V$$

Avec $C_V = \Sigma (a_i * C_{Vi})$, $a_i$ étant le $i^{ème}$ bit d'un mot binaire A de commande dont la valeur détermine l'état fermé ou ouvert de l'interrupteur correspondant au condensateur $C_{Vi}$, et avec $C_{Vi} = 2^i * C_{V0}$. On a également $C_V = k * C_{V0}$, avec k la valeur du mot A, k étant un entier variant entre 0 et $2^n-1$, n étant le nombre de bit du mot A.

Dans la fonction de transfert H(p), une valeur de capacité est toujours associée à une valeur de résistance. Ce couple résistance-condensateur est connu sous le nom de cellule RC. Les condensateurs $C'_1$ et $C'_2$ ont pour but de compenser les erreurs de valeur du couple RC.

Pour un couple RC donné, les valeurs nominales sont $R_N$ et $C_N$, cependant ces valeurs nominales sont modifiées respectivement par les erreurs $\delta$ et $\varepsilon$ sur les composants. On a alors :

$$RC = R_N * (1 + \delta) * C_N * (1 + \varepsilon)$$

Or comme indiqué, la valeur de CN comporte une partie variable visant à obtenir $RC=R_N C_N$, d'où l'équation suivante pour obtenir les valeurs de $C_F$ et $C_V$:

$$R_N C_N = R_N * (1 + \delta) * (C_F + C_V) * (1 + \varepsilon)$$

L'équation donne en situation de pire cas les deux inéquations suivantes :

$$C_N \geq (1 + \delta_{MAX}) * (1 + \varepsilon_{MAX}) * C_F$$

$$C_N \leq (1 + \delta_{MIN}) * (1 + \varepsilon_{MIN}) * (C_F + C_{VMAX})$$

Si l'on pose le même calcul en considérant les résistances comme éléments variables, des inéquations similaires sont obtenues. Pour l'amplificateur d'erreur 12, il est préférable de faire varier les condensateurs plutôt que les résistances parce que des résistances variables commutées introduiraient des capacités parasites qui modifieraient la fonction de transfert en signaux variables H(p). Les condensateurs variables disposent également de condensateurs parasites en parallèle mais cela ne fait que modifier la valeur globale du condensateur qui est lui-même corrigé. De plus, un condensateur couplé avec des condensateurs parasite reste globalement un condensateur.

L'homme du métier peut remarquer qu'il n'est pas aisé sur l'amplificateur d'erreur 12 de réaliser des mesures permettant de déterminer l'ajustement à effectuer sur les condensateurs $C'_1$ et $C'_2$. Astucieusement, il convient de remarquer que dans un circuit intégré, les erreurs de valeur peuvent être importantes mais que pour des composants de même nature placés à proximité les uns des autres, ces erreurs sont pratiquement les mêmes. En l'occurrence, le convertisseur continu/continu est suffisamment petit pour que l'on puisse considérer que tous les composants de même nature subissent une même erreur.

Par composant de même nature il faut comprendre les composants réalisés par les mêmes procédés de fabrication. A titre d'exemple, deux résistances sont de même nature si elles sont réalisées simultanément pendant les mêmes étapes du procédé de fabrication. Elles seront réalisées avec les mêmes matériaux qui auront subi les mêmes erreurs de concentration, les mêmes erreurs d'alignement et les mêmes erreurs d'épaisseur. En outre, ces composants de même nature étant à proximité dans le même circuit, ils sont à la même température. Deux composants de même nature présentent une même erreur et une même dérive de valeur.

Plutôt que de déterminer la valeur variable des condensateurs $C'_1$ et $C'_2$ dans l'amplificateur d'erreur 12, l'invention propose d'effectuer cette correction dans un autre circuit comportant une cellule RC, par exemple dans le générateur de rampe 13. Il est à noter que s'il n'y avait pas d'autre cellule RC dans le convertisseur continu/continu, il aurait été possible de rajouter un circuit simple comportant une cellule RC facilement compensable.

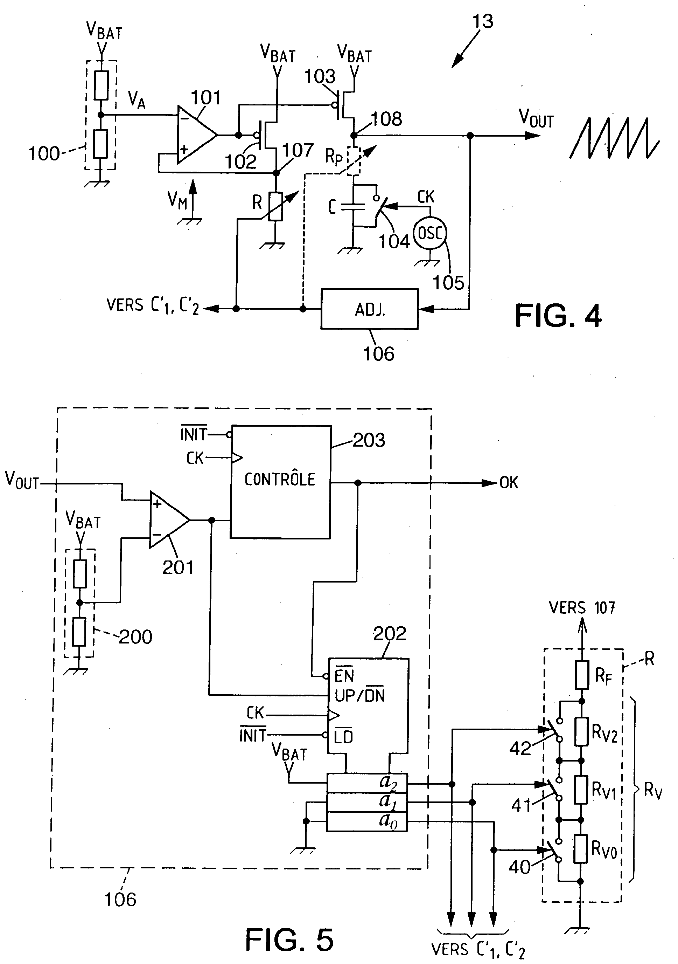

Le générateur de rampe 13, représenté sur la figure 4, correspond à un circuit simple mettant en oeuvre une cellule RC facilement compensable. Le générateur de rampe 13 comporte un pont diviseur de tension 100, un amplificateur opérationnel 101, une paire de transistors 102 et 103, une résistance R, un condensateur C, un interrupteur 104, un oscillateur 105 et un circuit d'étalonnage 106.

Le pont diviseur de tension 100 est un pont de résistances en série. Les résistances du pont diviseur 100 sont affectées d'une erreur sur leurs valeur, mais cette erreur étant la même pour les deux résistances, l'erreur est compensée.

Le pont diviseur 100 est connecté entre une tension de batterie et une tension de masse pour fournir une tension de référence $V_A$ à une entrée négative de l'amplificateur opérationnel 101. La sortie de l'amplificateur opérationnel 101 est connectée, d'une part, à la grille du transistor 102 et, d'autre part, à la grille du transistor 103. Une entrée positive de l'amplificateur opérationnel 101 est connectée au noeud 107 formé par une première borne de la résistance R et le drain du transistor 102. Une deuxième borne de la résistance R est connectée à la masse. La source du transistor 102 est connectée à un conducteur fournissant la tension de batterie $V_{BAT}$. L'amplificateur opérationnel 101 et le transistor 102 se comportent vis-à-vis du noeud 107 comme un amplificateur suiveur. Le noeud 107 est ainsi positionné au potentiel de référence $V_A$.

La source du transistor 103 est connectée à un conducteur fournissant la tension de batterie $V_{BAT}$. Le drain du transistor 103 est connecté au noeud 108 qui forme la sortie du générateur de rampe 13. Une première borne du condensateur C est connectée au noeud 108. Une deuxième borne du condensateur C est reliée à la masse. Le condensateur C est court-circuité par l'interrupteur 104. L'interrupteur 104 est commandé par l'oscillateur 105. Le circuit d'étalonnage 106 a une entrée connectée au noeud 108, et une sortie reliée, d'une part, à une borne de commande de la résistance R et, d'autre part, aux bornes de commande des condensateurs $C'_1$ et $C'_2$.

Les transistors 102 et 103 sont des transistors PMOS identiques commandés par une même tension grille-source donc ils fournissent sur leur drain un même courant. Or le courant fourni par le transistor 102 est fixé par la résistance R pour mettre le noeud 107 à un potentiel égal à la tension de référence $V_A$. Le courant traversant les canaux de conduction des transistors 102 et 103 est donc égal à $V_A / R$.

La sortie du générateur de rampe 13 est reliée au comparateur 14 dont le courant d'entrée est considéré nul. Par ailleurs, le courant d'entrée du circuit d'étalonnage 106 est également considéré nul. Par conséquent le courant de drain du transistor 103 traverse le condensateur C lorsque l'interrupteur 104 est ouvert, et traverse l'interrupteur 104 lorsque celui-ci est fermé.

L'oscillateur 105 est un circuit oscillant qui fournit un signal CK constitué d'un train de brèves impulsions espacées d'une période T. L'oscillateur 105 n'est pas soumis à une variation de constante RC, il est par exemple basé sur un oscillateur en anneau. Lors d'une impulsion, l'interrupteur 104 se ferme et décharge très rapidement le condensateur C. La tension $V_{OUT}$ du noeud 108 est ramenée à la tension de masse. Entre deux impulsions, l'interrupteur 104 est ouvert et le condensateur se charge à courant constant égal au courant de drain du transistor 103. A la fin de la période T, la tension $V_{OUT}$ se trouve alors être égale à une tension maximale $V_{OUTMAX}$.

$$V_{OUTMAX} = \frac{T \times V_A}{R \times C}$$

La résistance R est une résistance ajustable commandée par le circuit d'étalonnage 106. Durant une phase d'étalonnage, le circuit d'étalonnage compare la valeur $V_{OUTMAX}$ avec une valeur souhaitée et modifie en conséquence la valeur de la résistance R pour compenser les erreurs sur les composants R et C.

Il est à noter que le générateur peut comporter une résistance de pied $R_P$ en série avec le condensateur C si l'on désire fixer une tension minimum pour le signal de sortie. L'ajout de cette résistance $R_P$ ne change rien dans le principe de l'étalonnage mais doit être une résistance variable subissant une variation proportionnelle à la variation de R. Pour la suite, cette résistance $R_P$ n'est pas ajoutée pour des raisons de simplification.

La figure 5 montre un exemple de réalisation du circuit d'étalonnage 106 et de la résistance R. La résistance R comporte une résistance fixe $R_F$ en série avec des résistances $R_{V2}$, $R_{V1}$ et $R_{V0}$. Chaque résistance $R_{V0}$, $R_{V1}$ ou $R_{V2}$ est court-circuitable par l'intermédiaire d'un interrupteur 40, 41 ou 42 respectivement. Les interrupteurs 40 à 42 sont par exemple réalisés avec des transistors MOS.

Sur la figure 5, la partie variable $R_V$ comporte uniquement 3 résistances $R_{V0}$, $R_{V1}$ et $R_{V2}$. Un nombre plus important de résistance améliore la précision de la compensation. Les valeurs des résistances $R_{V0}$, $R_{V1}$ et $R_{V2}$ correspondent à une décomposition binaire de la partie variable $R_V$ de la résistance R. Si on considère la valeur nominale $R_N$ de la résistance R, cette valeur nominale peut s'écrire :

$$R_N = R_F + R_V$$

Avec $R_V = \Sigma (a_i * R_{Vi})$, $a_i$ étant le $i^{ème}$ bit d'un mot binaire A de commande dont la valeur détermine l'état fermé ou ouvert de l'interrupteur 40 à 42 correspondant à la résistance $R_{Vi}$, et avec $R_{Vi} = 2^i * R_{V0}$. On a également $R_V = k * R_{V0}$, avec k la valeur du mot A, k étant un entier variant entre 0 et $2^n-1$, n étant le nombre de bit du mot A.

Dans le générateur de rampe 13, la tension maximale $V_{OUTMAX}$ dépend d'une valeur de condensateur C associée à une valeur de résistance R. Ce couple résistance-condensateur constitue une cellule RC. La résistance R compense les erreurs de ce couple RC. Ici, la résistance R travaille à courant constant. Les capacités parasites liées à la commutation de résistances n'ont pas d'effet sur le circuit.

Pour ce couple RC, les valeurs nominales sont $R_N$ et $C_N$, cependant ces valeurs nominales sont modifiées respectivement par les erreurs $\delta$ et $\varepsilon$ sur les composants. Ces erreurs $\delta$ et $\varepsilon$ sont les mêmes que pour l'amplificateur d'erreur 12 dans la mesure où les résistances sont de même nature et les condensateurs sont également de même nature. On a alors :

$$RC = R_N * (1 + \delta) * C_N * (1 + \varepsilon)$$

Or comme indiqué, la résistance R comporte une partie variable visant à obtenir $RC = R_N C_N$, d'où l'équation suivante pour obtenir les valeurs de $R_F$ et $R_V$ :

$$R_N C_N = (R_F + R_V) * (1 + \delta) * C_N * (1 + \varepsilon)$$

L'équation donne en situation de pire cas les deux inéquations suivantes :

$$R_N \geq (1 + \delta_{MAX}) * (1 + \varepsilon_{MAX}) * R_F$$

$$R_N \leq (1 + \delta_{MIN}) * (1 + \varepsilon_{MIN}) * (R_F + R_{VMAX})$$

Grâce à ces inéquations, identiques à celles obtenues pour les condensateurs de l'amplificateur d'erreur 12, on peut définir la valeur de la résistance R :

$$R = R_F + (A * R_{V0})$$

Avec : $R_F = b * R_N$ et $A_{MAX} * R_{V0} = c * R_N$.

b et c étant des coefficients choisis qui vérifie les inéquations suivantes :

$$b \leq \frac{1}{(1 + \delta_{MAX})(1 + \varepsilon_{MAX})}$$

$$c \geq \frac{1}{(1 + \delta_{MIN})(1 + \varepsilon_{MIN})} - b$$

Pour que la correction soit identique, il convient de choisir les mêmes coefficients pour tous les composants variables qui sont commandé par le circuit d'étalonnage. A titre d'exemple, pour des valeurs d'erreurs $\delta_{MAX} = -\delta_{MIN} = 0,35$ et $\varepsilon_{MAX} = -\varepsilon_{MIN} = 0,2$ ; on peut choisir b = 0,6 et c = 1,4. La précision sur l'erreur $\alpha$ sur le couple RC devient alors égale à l'erreur sur un pas de R, c'est-à-dire sur $R_{V0}$ :

$$\alpha = \frac{c \times \delta}{2^n - 1}$$

Cette erreur $\alpha$ dépend du nombre n de bits du mot A et donc de la précision d'ajustement des composants variables. Pour c = 1,4 et n = 3, l'erreur maximale $\alpha_{MAX}$ est égale à 7%. Cette erreur $\alpha_{MAX}$ devient égale à 0,8% pour n = 6 et 0,2% pour n = 8. L'homme du métier modifiera donc n en fonction de la précision souhaitée. Le circuit d'étalonnage 106 se limite à n = 3 pour des raisons de simplification et de compréhension.

Le circuit d'étalonnage 106 comporte un pont diviseur de tension 200, un comparateur 201, un compteur 202 et un circuit de contrôle 203.

Le pont diviseur de tension 200 est constitué de deux résistances en série de même nature qui se compensent mutuellement puisqu'elles subissent les mêmes influences extérieures et qu'elles ont été fabriquées en même temps. Le pont diviseur 200 est connecté entre la tension de batterie $V_{BAT}$ et la tension de masse, et il fournit sur une sortie une tension maximum souhaitée $V_{MS}$.

Le comparateur 201 comporte une entrée négative reliée à la sortie du pont diviseur 200, une entrée positive reliée au noeud 108, et une sortie. Le comparateur 201 effectue une comparaison permanente entre la tension de sortie $V_{OUT}$ et la tension maximum souhaité $V_{MS}$. La sortie du comparateur 201 est dans un premier état, par exemple l'état « 1 », lorsque la tension $V_{OUT}$ est supérieure à la tension $V_{MS}$. La sortie du comparateur 201 est dans un deuxième état, par exemple l'état « 0 », lorsque la tension *$V_{OUT}$ est inférieure à la tension $V_{MS}$.

Le compteur 202 comporte une entrée de validation $\overline{EN}$ de comptage active à l'état bas, une entrée de comptage/décomptage $UP/\overline{DN}$, une entrée d'horloge, une entrée de pré-chargement $\overline{LD}$, trois entrées de données et trois sorties de données. L'entrée de validation $\overline{EN}$, lorsqu'elle est active, autorise le compteur à compter ou décompter. Cette entrée de validation $\overline{EN}$ est reliée à la sortie du circuit de contrôle 203. L'entrée de comptage/décomptage $UP/\overline{DN}$ indique, suivant son état, si le compteur doit s'incrémenter ou se décrémenter sur un front actif d'horloge. L'entrée d'horloge est reliée à l'oscillateur 105 et elle reçoit le signal CK. L'entrée de pré-chargement $\overline{LD}$ reçoit un signal d'initialisation $\overline{INIT}$. Lorsque l'entrée de pré-chargement $\overline{LD}$ est active, un chargement asynchrone des données présentes sur les entrées de données initialise le compteur. Les entrées de données sont reliées préférentiellement à la tension de batterie $V_{BAT}$ pour le bit de poids le plus fort, et à la tension de masse pour les autres bits. Lors de l'activation de l'entrée de pré-chargement $\overline{LD}$, le compteur se trouve positionné à une valeur moyenne. Les sorties de données sont reliées aux interrupteurs 30 à 32 et 40 à 42 des composants variables R, C'$_1$ et C'$_2$. Les sorties de données fournissent la valeur contenue dans le compteur 202. Le compteur incrémente sa valeur sur un front actif du signal CK si l'entrée de validation $\overline{EN}$ est active et si l'entrée de comptage/décomptage $UP/\overline{DN}$ est dans un état « 1 ». Le compteur décrémente sa valeur sur un front actif du signal CK si l'entrée de validation $\overline{EN}$ est active et si l'entrée de comptage/décomptage $UP/\overline{DN}$ est dans un état « 0 ».

Le circuit de contrôle 203 comporte une entrée reliée à la sortie du comparateur 201, une entrée d'horloge recevant le signal CK, une entrée d'initialisation recevant le signal $\overline{INIT}$, et une sortie reliée à l'entrée de validation $\overline{EN}$ du compteur 202 et fournissant un signal OK. Le signal OK est représentatif de l'état de l'étalonnage. Lorsque le signal OK est à « 0 », l'étalonnage est en cours. Lorsque le signal OK est à « 1 », l'étalonnage est terminé. Ce circuit détecte et mémorise l'état de sortie du comparateur 201 lors des fronts actifs du signal CK. La sortie du comparateur indique, aux instants correspondant à ces fronts actifs, si la tension de sortie maximum $V_{OUTMAX}$ est supérieure ou inférieure à la tension maximum souhaitée $V_{MS}$. Lorsque la tension de sortie maximum $V_{OUTMAX}$ passe d'une valeur supérieure à une valeur inférieure, ou d'une valeur inférieure à une valeur supérieure par rapport à la tension maximum souhaitée $V_{MS}$, le signal OK passe au niveau « 1 ».

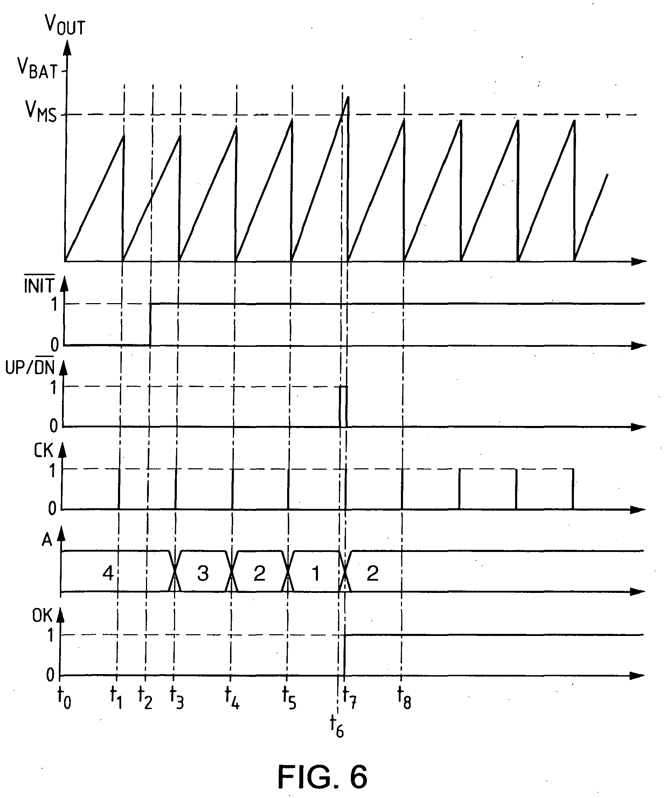

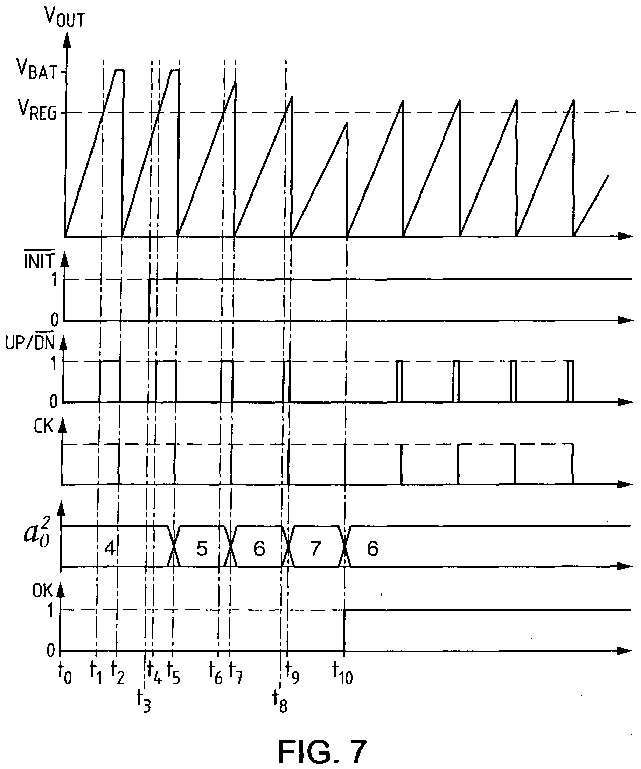

Le fonctionnement du circuit d'étalonnage 106 va à présent être décrit à l'aide des figures 6 et 7. La figure 6 correspond à un étalonnage pour une erreur négative sur le produit RC qui correspond à $(1 + \delta) * (1 + \varepsilon) < 1$.

Le début de l'étalonnage commence à l'instant $t_0$ par une mise à l'état « 0 » du signal d'initialisation $\overline{INIT}$. Le signal OK est mis à « 0 ». Le compteur 202 charge la valeur A, par exemple égale à « 4 » pour un compteur trois bits.

Le condensateur C se charge avec un courant égal à $\dfrac{V_A}{(R_F + 4R_{V0})(1+\delta)}$.

Entre $t_0$ et $t_1$, la sortie du comparateur est restée à l'état « 0 » car la tension de sortie $V_{OUT}$ est toujours restée en dessous de la tension maximum souhaitée $V_{MS}$. A l'instant $t_1$. l'impulsion du signal CK décharge le condensateur C et la tension $V_{OUT}$ devient égale à 0V. L'impulsion à l'instant $t_1$ est inopérante sur le compteur 202 car le signal d'initialisation $\overline{INIT}$ est toujours actif. Le condensateur C se charge avec un courant égal à $\dfrac{V_A}{(R_F + 4R_{V0})(1+\delta)}$.

A l'instant $t_2$, le signal d'initialisation $\overline{INIT}$ devient inactif et l'étalonnage commence.

Entre $t_1$ et $t_3$, la sortie du comparateur est restée à « 0 » car la tension de sortie $V_{OUT}$ est toujours restée en dessous de la tension maximum souhaitée $V_{MS}$.

A l'instant $t_3$, la sortie du comparateur qui correspond à l'entrée $UP/\overline{DN}$ est à l'état « 0 ». Le signal OK est à « 0 ». L'impulsion du signal CK décrémente alors le compteur 202 et le positionne à la valeur « 3 ». Toujours à l'instant $t_3$, l'impulsion du signal CK décharge le condensateur C et la tension $V_{OUT}$ devient égale à 0V. Le condensateur C se charge ensuite avec un courant égal à $\dfrac{V_A}{(R_F + 3R_{V0})(1+\delta)}$.

Entre $t_3$ et $t_4$, la sortie du comparateur reste à l'état « 0 » car la tension de sortie $V_{OUT}$ est en dessous de la tension maximum souhaitée $V_{MS}$.

A l'instant $t_4$, tout se déroule comme à l'instant $t_3$, et le compteur se décrémente à la valeur « 2 ». Le condensateur C se charge ensuite avec un courant égal à $\dfrac{V_A}{(R_F + 2R_{V0})(1 + \delta)}$.

Entre $t_4$ et $t_5$, la sortie du comparateur 201 reste à « 0 » car la tension de sortie $V_{OUT}$ reste en dessous de la tension maximum souhaitée $V_{MS}$.

A l'instant $t_5$, tout se déroule comme à l'instant $t_4$, et le compteur se décrémente à la valeur « 1 ». Le condensateur C se charge ensuite avec un courant égal à $\dfrac{V_A}{(R_F + R_{V0})(1 + \delta)}$.

Entre $t_5$ et $t_6$, la sortie du comparateur est à l'état « 0 » car la tension de sortie $V_{OUT}$ est en dessous de la tension maximum souhaitée $V_{MS}$. Mais, à l'instant $t_6$, la tension de sortie $V_{OUT}$ devient supérieure à la tension maximum souhaitée $V_{MS}$. La sortie du comparateur 201 passe à « 1 » et reste à « 1 » jusqu'à l'impulsion de l'instant $t_7$.

A l'instant $t_7$, la sortie du comparateur qui correspond à l'entrée *UP/$\overline{DN}$* est à l'état « 1 ». Le signal OK est à « 0 ». L'impulsion du signal CK incrémente alors le compteur 202 et le positionne à la valeur « 2 ». Le signal OK bascule alors à l'état « 1 ». Toujours à l'instant $t_7$, l'impulsion du signal CK décharge le condensateur C et la tension $V_{OUT}$ devient égale à 0V. Le condensateur C se charge ensuite avec un courant égal à $\dfrac{V_A}{(R_F + 2R_{V0})(1 + \delta)}$.

Entre $t_7$ et $t_8$, la sortie du comparateur 201 reste à l'état « 0 » car la tension de sortie $V_{OUT}$ reste en dessous de la tension maximum souhaitée $V_{MS}$.

A l'instant $t_8$, le signal OK est à « 1 ». L'impulsion du signal CK est inopérante sur le compteur 202 qui reste à la valeur « 2 ». Le condensateur C se charge alors après chaque impulsion avec un courant égal à $\dfrac{V_A}{(R_F + 2R_{V0})(1 + \delta)}$. L'étalonnage du générateur de rampe est terminé mais également l'étalonnage de tous les couples de type RC de l'amplificateur d'erreur 12.

La figure 7 correspond à un étalonnage pour une erreur positive sur le produit RC qui correspond à $(1 + \delta) * (1 + \varepsilon) > 1$.

Le début de l'étalonnage commence à l'instant $t_0$ par une mise à l'état « 0 » du signal d'initialisation $\overline{INIT}$. Le signal OK est mis à zéro. Le compteur 202 charge la valeur A, par exemple égale à « 4 » pour un compteur trois bits. Le condensateur C se charge avec un courant égal à $\dfrac{V_A}{(R_F + 4R_{V0})(1 + \delta)}$.

Entre $t_0$ et $t_1$, la sortie du comparateur 201 est à l'état « 0 » car la tension de sortie $V_{OUT}$ est en dessous de la tension maximum souhaitée $V_{MS}$. A l'instant $t_1$, la tension de sortie $V_{OUT}$ passe au-dessus de la tension maximum souhaitée $V_{MS}$ et la sortie du comparateur passe à l'état « 1 » jusqu'à l'instant $t_2$.

A l'instant $t_2$, l'impulsion du signal CK décharge le condensateur C et la tension $V_{OUT}$ devient égale à 0. L'impulsion de l'instant $t_2$ est inopérante sur le compteur 202 car le signal d'initialisation $\overline{INIT}$ est toujours actif. Le condensateur C se charge avec un courant égal à $\dfrac{V_A}{(R_F + 4R_{V0})(1 + \delta)}$.

A l'instant $t_3$, le signal d'initialisation $\overline{INIT}$ devient inactif et l'étalonnage commence.

Entre $t_2$ et $t_4$, la sortie du comparateur 201 est à l'état « 0 » car la tension de sortie $V_{OUT}$ est en dessous de la tension maximum souhaitée $V_{MS}$. A l'instant $t_4$, la tension de sortie $V_{OUT}$ passe au-dessus de la tension maximum souhaitée $V_{MS}$ et la sortie du comparateur 201 passe à l'état « 1 » jusqu'à l'instant $t_5$.

A l'instant $t_5$, la sortie du comparateur 201 qui correspond à l'entrée *UP/$\overline{DN}$* est à l'état « 1 ». Le signal OK est à « 0 ». L'impulsion du signal CK incrémente alors le compteur 202 et le positionne à la valeur « 5 ». Toujours à l'instant $t_3$, l'impulsion du signal CK décharge le condensateur C et la tension $V_{OUT}$ devient égale à 0V. Le condensateur C se charge ensuite avec un courant égal à $\dfrac{V_A}{(R_F + 5R_{V0})(1 + \delta)}$.

**EP 1 684 427 B1**

Entre $t_5$ et $t_6$, la sortie du comparateur 201 est à l'état « 0 ». A $t_6$, la tension $V_{OUT}$ passe au-dessus de la tension $V_{MS}$. De $t_6$ à $t_7$, la sortie du comparateur 201 est à l'état « 1 ».

A l'instant $t_7$, la sortie du comparateur 201 est à l'état « 1 ». Le signal OK est à « 0 ». L'impulsion du signal CK incrémente alors le compteur 202 et le positionne à la valeur « 6 ». Toujours à l'instant $t_7$, l'impulsion du signal CK décharge le condensateur C et la tension $V_{OUT}$ devient égale à 0V. Le condensateur C se charge ensuite avec un courant égal à $\dfrac{V_A}{(R_F + 6R_{V0})(1+\delta)}$.

Entre $t_7$ et $t_8$, la sortie du comparateur est à l'état « 0 ». A l'instant $t_8$, la tension de sortie $V_{OUT}$ devient supérieure à la tension maximum souhaitée $V_{MS}$. La sortie du comparateur 201 passe à « 1 » et reste à « 1 » jusqu'à l'impulsion de l'instant $t_9$.

A l'instant $t_9$, la sortie du comparateur est à l'état « 1 ». Le signal OK est à « 0 ». L'impulsion du signal CK incrémente alors le compteur 202 et le positionne à la valeur « 7 ». Toujours à l'instant $t_9$, l'impulsion du signal CK décharge le condensateur C et la tension $V_{OUT}$ devient égale à 0V. Le condensateur C se charge ensuite avec un courant égal à $\dfrac{V_A}{(R_F + 7R_{V0})(1+\delta)}$.

Entre $t_9$ et $t_{10}$, la sortie du comparateur reste à l'état « 0 ».

A l'instant $t_{10}$, la sortie du comparateur est à l'état « 0 ». Le signal OK est à « 0 ». L'impulsion du signal CK décrémente alors le compteur 202 et le positionne à la valeur « 6 ». Le signal OK bascule alors à l'état « 1 ». Toujours à l'instant $t_{10}$, l'impulsion du signal CK décharge le condensateur C et la tension $V_{OUT}$ devient égale à 0V. Le condensateur C se charge ensuite avec un courant égal à $\dfrac{V_A}{(R_F + 6R_{V0})(1+\delta)}$.

Après $t_{10}$, le signal OK est à « 1 ». L'impulsion du signal CK est inopérante sur le compteur 202 qui reste à la valeur « 6 ». Le condensateur C se charge alors après chaque impulsion avec un courant égal à $\dfrac{V_A}{(R_F + 6R_{V0})(1+\delta)}$.

L'étalonnage du générateur de rampe est terminé mais également l'étalonnage de tous les couples de type RC de l'amplificateur d'erreur 12.

La précision de l'étalonnage dépend du nombre n de bits du mot A. Pour augmenter la précision, il convient d'augmenter le nombre de bits. Le temps d'étalonnage dépend des erreurs $\delta$ et $\varepsilon$ mais aussi du nombre n de bits de A. Dans une situation de pire cas, le nombre d'impulsions nécessaire à l'étalonnage est égal à $2^{n-1}+1$.

Statistiquement, cette situation de pire cas se produit rarement car les procédé de fabrication sont centrés et les erreurs $\delta$ et $\varepsilon$ sont inférieures à 1% pour 60% des circuits produits. On peut améliorer la vitesse d'étalonnage en choisissant d'avoir une valeur fixe $R_F$ nulle et une valeur variable maximum égale à deux fois la valeur nominale $R_{VMAX}$ = 2* $R_N$. Le positionnement du compteur à A/2 permet d'être très proche de la valeur à atteindre dans 60% des cas.

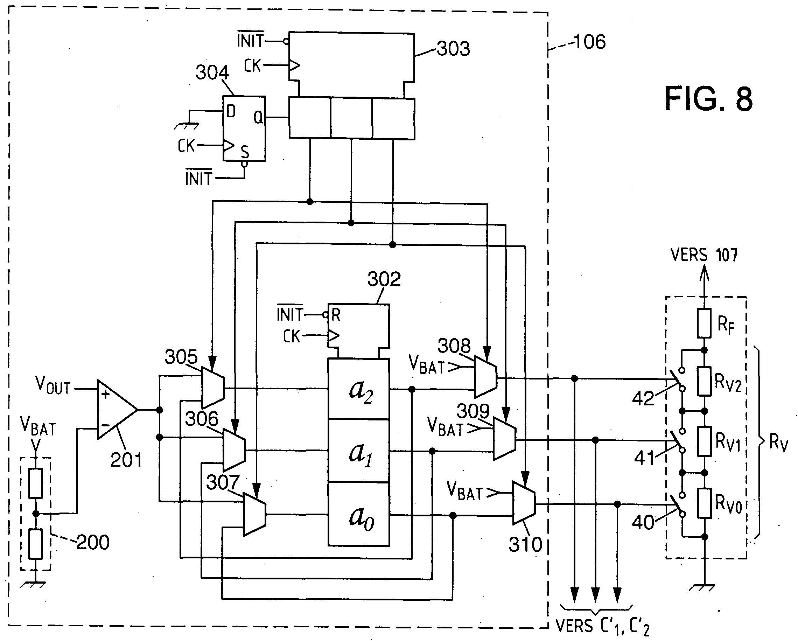

Cependant il est possible d'améliorer le temps d'étalonnage indépendamment des valeurs d'erreurs $\delta$ et $\varepsilon$. La figure 8 montre une variante de circuit d'étalonnage 106 qui met en oeuvre une évaluation dite de pesées successives.

Le circuit d'étalonnage 106 comporte un pont diviseur de tension 200, un comparateur 201, un registre 302, un registre à décalage 303, une bascule 304 et six multiplexeurs 305 à 310.

Le pont diviseur de tension 200 et le comparateur 201 sont les mêmes que pour le circuit précédemment décrit.

Le registre 302 comporte une entrée d'initialisation recevant le signal d'initialisation $\overline{INIT}$, une entrée d'horloge recevant le signal CK, trois entrées de données et trois sorties de données. L'entrée d'initialisation, active à l'état bas, remet à zéro le contenu du registre 302. Sur chaque front actif du signal d'horloge, le registre 302 mémorise les données présentes sur les entrées de données. Les données fournies sur les sorties correspondent aux données mémorisées.

Le registre à décalage 303 comporte une entrée d'initialisation recevant le signal d'initialisation $\overline{INIT}$, une entrée d'horloge recevant le signal CK, une entrée de donnée et trois sorties de données. L'entrée d'initialisation, active à l'état bas, remet à zéro le contenu du registre à décalage 303. Sur chaque front actif du signal d'horloge, le registre à décalage 303 décale son contenu d'un bit, des poids forts vers les poids faibles, et mémorise en bit de poids le plus fort le bit présent sur son entrée de donnée. Les données fournies sur les sorties correspondent aux données mémorisées dans le registre à décalage 303.

La bascule 304 est une bascule D qui comporte une entrée D de donnée reliée à la masse, une entrée d'horloge recevant le signal CK, une entrée de mise à « 1 » recevant le signal d'initialisation $\overline{INIT}$, et une sortie Q de donnée. La sortie Q est reliée à l'entrée de donnée du registre à décalage 303.

Les six multiplexeurs 305 à 310 comportent chacun une première et une deuxième entrées de données, une entrée de sélection et une sortie. Chaque multiplexeur 305 à 310 relie sa sortie à sa première entrée lorsque l'entrée de sélection est à l'état « 1 » et relie sa sortie à sa deuxième entrée lorsque l'entrée de sélection est à un état « 0 ».

Les sorties des multiplexeurs 305 à 307 sont respectivement connectées aux entrées de données du registre 302. Les premières entrées des multiplexeurs 305 à 307 sont connectées à la sortie du comparateur 201. Les deuxièmes entrées des multiplexeurs 305 à 307 sont respectivement connectées aux sorties du registre 302. Les entrées de sélections des multiplexeurs 305 à 307 sont respectivement connectées aux sorties du registre à décalage 303.

Les sorties des multiplexeurs 308 à 310 sont respectivement connectées aux entrées de commande des interrupteurs 42 à 40. Les premières entrées des multiplexeurs 308 à 310 reçoivent la tension de batterie $V_{BAT}$. Les deuxièmes entrées des multiplexeurs 308 à 310 sont respectivement connectées aux sorties du registre 302. Les entrées de sélections des multiplexeurs 308 à 310 sont respectivement connectées aux sorties du registre à décalage 303.

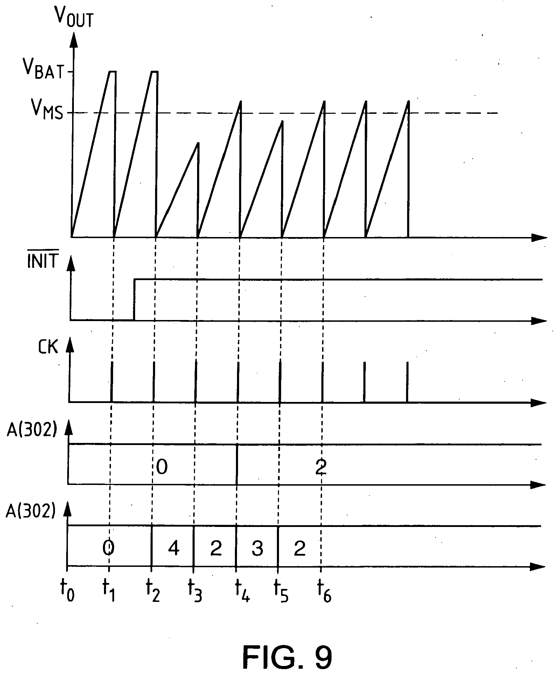

Le fonctionnement du circuit d'étalonnage 106 de la figure 8 est expliqué à l'aide de la figure 9.

A l'instant $t_0$, le signal d'initialisation $\overline{INIT}$ est mis à « 0 » pour indiquer le début de l'initialisation. Tant que le signal d'initialisation $\overline{INIT}$, les registres 302 et 303 sont forcés à zéro et la bascule 304 est forcée à « 1 ». A l'instant $t_1$, l'impulsion du signal CK est inopérante sur les registres 302 et 303.

De $t_0$ jusqu'à $t_2$, les entrées de sélection des multiplexeurs 308 à 310 sont à « 0 ». Les interrupteurs 40 à 42 sont reliés au contenu du registre qui vaut « 0 ». Sur la figure 6, la valeur A vue par la résistance R est notée A(R) et la valeur A contenue dans le registre 302 est notée A(302). Le condensateur C se charge avec un courant égal à

$$\frac{V_A}{R_F(1+\delta)}.$$

Entre $t_1$ et $t_2$, le signal d'initialisation $\overline{INIT}$ est repositionné à « 1 » et l'étalonnage commence.

Peu avant l'instant $t_2$, les entrées de sélection des multiplexeurs 305 à 307 sont à « 0 » les entrées du registre 302 sont reliées à ses sorties. La sortie de la bascule 304 fournit un « 1 ».

Lors de l'impulsion du signal CK à l'instant $t_2$, le registre 302 mémorise son propre contenu. Le registre 303 mémorise un « 1 » en bit de poids fort. La bascule 304 mémorise un « 0 ». Le condensateur C est court-circuité et la tension $V_{OUT}$ devient nulle.

Après $t_2$ et jusqu'à $t_3$, le multiplexeur 308 reçoit un « 1 » sur son entrée de sélection et relie sa sortie à sa première entrée. Les multiplexeurs 309 et 310 reçoivent des « 0 » sur leurs entrées de sélection et relient leurs sorties à leurs deuxièmes entrées. La valeur A vue par la résistance est égale à « 4 » alors que le contenu du registre est égal à « 0 ». Le condensateur C se charge avec un courant égal à $\dfrac{V_A}{(R_F + 4R_{V0})(1+\delta)}$.

Peu avant l'instant $t_3$, l'entrée de sélection du multiplexeur 305 est à « 1 », reliant l'entrée correspondant au poids fort du registre 302 à la sortie du comparateur 201. La tension $V_{OUT}$ étant inférieure à la tension $V_{MS}$, la sortie du comparateur 201 est à « 0 ». Les entrées de sélection des multiplexeurs 306 et 307 sont à « 0 », reliant les deux entrées de poids faible du registre 302 à ses sorties de poids faible. La sortie de la bascule 304 fournit un « 0 ».

A l'instant $t_3$ et en réponse à l'impulsion du signal CK, le registre 302 mémorise la valeur initialement présente sur ses entrées, à savoir la valeur « 0 ». Le registre 303 décale son contenu d'un bit en direction des poids faibles et charge un « 0 » en bit de poids fort. La bascule 304 mémorise un « 0 ». Le condensateur C est court-circuité et la tension $V_{OUT}$ devient nulle.

Après $t_3$ et jusqu'à $t_4$, le multiplexeur 309 reçoit un « 1 » sur son entrée de sélection et relie sa sortie à sa première entrée. Les multiplexeurs 308 et 310 reçoivent des « 0 » sur leurs entrées de sélection et relient leurs sorties à leurs deuxièmes entrées. La valeur A vue par la résistance est égale à « 2 » alors que le contenu du registre est égal à « 0 ». Le condensateur C se charge avec un courant égal à $\dfrac{V_A}{(R_F + 2R_{V0})(1+\delta)}$.

Peu avant l'instant $t_4$, l'entrée de sélection du multiplexeur 306 est à « 1 », reliant l'entrée correspondant au poids intermédiaire du registre 302 à la sortie du comparateur 201. La tension $V_{OUT}$ étant supérieure à la tension $V_{MS}$, la sortie du comparateur 201 est à « 1 ». Les entrées de sélection des multiplexeurs 305 et 307 sont à « 0 », reliant les deux entrées de poids fort et faible du registre 302 à ses sorties de poids fort et faible. La sortie de la bascule 304 fournit un « 0 ».

A l'instant $t_4$ et en réponse à l'impulsion du signal CK, le registre 302 mémorise la valeur initialement présente sur ses entrées, à savoir la valeur « 2 ». Le registre 303 décale son contenu d'un bit en direction des poids faibles et charge un « 0 » en bit de poids fort. La bascule 304 mémorise un « 0 ». Le condensateur C est court-circuité et la tension $V_{OUT}$ devient nulle.

Après $t_4$ et jusqu'à $t_5$, le multiplexeur 310 reçoit un « 1 » sur son entrée de sélection et relie sa sortie à sa première entrée. Les multiplexeurs 308 et 309 reçoivent des « 0 » sur leurs entrées de sélection et relient leurs sorties à leurs deuxièmes entrées. La valeur A vue par la résistance est égale à « 3 » alors que le contenu du registre est égal à « 2 ». Le condensateur C se charge avec un courant égal à $\dfrac{V_A}{(R_F + 3R_{V0})(1+\delta)}$.

Peu avant l'instant $t_5$, l'entrée de sélection du multiplexeur 307 est à « 1 », reliant l'entrée correspondant au poids faible du registre 302 à la sortie du comparateur 201. La tension $V_{OUT}$ étant inférieure à la tension $V_{MS}$, la sortie du comparateur 201 est à « 0 ». Les entrées de sélection des multiplexeurs 305 et 306 sont à « 0 », reliant les deux entrées de poids fort du registre 302 à ses sorties de poids fort. La sortie de la bascule 304 fournit un « 0 ».

A l'instant $t_5$ et en réponse à l'impulsion du signal CK, le registre 302 mémorise la valeur initialement présente sur ses entrées, à savoir la valeur « 2 ». Le registre 303 décale son contenu d'un bit en direction des poids faibles et charge un « 0 » en bit de poids fort. La bascule 304 mémorise un « 0 ». Le condensateur C est court-circuité et la tension $V_{OUT}$ devient nulle.

Après $t_5$, l'étalonnage est terminé. Le registre 303 est positionné à « 0 » et ne peut que rester à « 0 ». Les multiplexeurs 305 à 310 reçoivent des « 0 » sur leurs entrées de sélection et relient leurs sorties à leurs deuxièmes entrées. La valeur A vue par la résistance est égale à la valeur A contenue dans le registre 302, qui est par exemple égal à « 2 ». Le condensateur C se charge avec un courant égal à $\dfrac{V_A}{(R_F + 2R_{V0})(1+\delta)}$. Lors de chaque impulsion du signal CK, le registre 303 décale des « 0 » et le registre 302 mémorise son propre contenu. Les impulsions du signal CK ne servent plus qu'à décharger le condensateur C.

Ce circuit d'étalonnage permet de réaliser l'étalonnage à l'aide d'un nombre fixe d'impulsions du signal CK. Le nombre fixe d'impulsions est égal à n+1, avec n le nombre de bits du mot A.

De nombreuses variantes de l'invention sont réalisables. L'invention s'applique à tout type de circuit et pas seulement à un convertisseur continu/continu. Le circuit d'étalonnage est utilisé dans un générateur de rampe, mais il pourrait être placé dans un autre circuit pourvu que celui-ci soit simple.

Dans la présente description, l'étalonnage se fait sur une résistance et s'applique sur des condensateurs. L'inverse aurait pu se faire dans la mesure où il aurait été plus pratique de faire l'étalonnage d'un condensateur.

Un point important est la proportionnalité entre le composant variable. Les coefficients b et c à appliquer aux valeur nominales des composants pour obtenir les valeurs fixe et variable des composants, doivent, de préférence, être les mêmes. Il est possible de tolérer une légère différence sur ces coefficients mais celle-ci introduit une légère erreur.

Egalement, les composants variables décrits disposent d'une même précision. Cela n'est pas nécessaire, il est possible d'effectuer un étalonnage d'un composant sur huit bits mais de n'utiliser qu'un nombre de bits réduits à par exemple six pour commander les autres composants. Dans ce cas, les bits de poids fort sont utilisés.

L'exemple de réalisation de la présente description se rapporte à un circuit réalisé en circuit intégré car l'invention est particulièrement intéressante pour les circuits intégrés. Cependant, cette invention peut également être utilisée avec des composant discrets mais de manière plus limitée. Les composants de même nature ne présentent pas la particularité d'avoir la même erreur de valeur car deux composants discrets de valeurs différentes ne peuvent être fabriqués en même temps avec les mêmes étapes. Cependant, si ces composants sont rigoureusement fait par le même fabricant avec les mêmes matériaux, les composants ont une dérive dynamique (notamment en température identique. Il est alors possible de compenser dynamiquement ces valeurs.

L'invention concerne également un procédé d'étalonnage d'un premier couple de composants constitué d'une résistance R et d'un condensateur C, et d'au moins un deuxième couple de composants constitué d'une résistance $R_1$-$R_3$ de même nature que la résistance du premier couple et d'un condensateur $C'_1$, $C'_2$ de même nature que le condensateur du premier couple, l'un des deux composants du premier couple étant un composant ajustable R, et l'un des deux composants du deuxième couple étant un composant ajustable $C'_1$, $C'_2$, dans lequel on réalise l'ajustement du composant ajustable du premier couple pour compenser l'erreur sur le produit de la résistance par la capacité dudit premier couple, et dans lequel on applique le même ajustement sur le composant ajustable du deuxième couple.

Dans des modes de réalisation du procédé, on prévoit en outre les dispositions suivantes, prises isolément ou en combinaison :

- la valeur d'ajustement A du composant ajustable du premier couple est appliquée proportionnellement à la valeur du composant ajustable du deuxième couple par rapport à la valeur du composant ajustable du premier couple ;
- le composant ajustable du premier couple est la résistance, et/ou le composant ajustable du deuxième couple est le condensateur ; et/ou
- les composants ajustables R, $C'_1$, $C'_2$ des premier et deuxième couples comportent chacun une partie fixe $R_F$, $C_F$

et une partie variable $R_V$, $C_V$, et le rapport b, c entre la partie fixe et la partie variable d'un composant variable est le même pour les premier et deuxième couples.

**Revendications**

1.   Circuit électronique comportant :

- un premier couple de composants constitué d'une résistance (R) et d'un condensateur (C), la résistance étant le composant ajustable du premier couple, et
- au moins un deuxième couple de composants constitué d'une résistance ($R_1$-$R_3$) réalisée simultanément et par le même procédé de fabrication que la résistance du premier couple et d'un condensateur ($C'_1$, $C'_2$) réalisé simultanément et par le même procédé de fabrication que le condensateur du premier couple, le condensateur étant le composant ajustable du second couple,
- un circuit d'étalonnage (106) pour produire une valeur d'ajustement du composant ajustable (R) du premier couple afin de compenser l'erreur sur le produit de la résistance par la capacité dudit premier couple, la valeur d'ajustement du composant ajustable du premier couple étant en outre appliquée proportionnellement à la valeur du composant ajustable du deuxième couple par rapport à la valeur du composant ajustable du premier couple.

2.   Circuit électronique selon la revendication 1, dans lequel les composants ajustables (R, $C'_1$, $C'_2$) des premier et deuxième couples comportent chacun une partie fixe ($R_F$, $C_F$) et une partie variable ($R_V$, $C_V$), et dans lequel le rapport (b, c) entre la partie fixe et la partie variable d'un composant variable est le même pour les premier et deuxième couples.

3.   Circuit électronique selon l'une des revendications 1 à 2, comportant un générateur de rampe (13) qui inclut le premier couple de composants (R, C) et dans lequel le circuit d'étalonnage (106) ajuste la valeur du composant ajustable (R) du premier couple en fonction du signal de sortie du générateur de rampe (13).

4.   Circuit électronique selon la revendication 3, dans lequel le circuit d'étalonnage (106) comporte un comparateur (201) pour comparer la tension maximale du signal de sortie ($V_{OUTMAX}$) du générateur de rampe avec une tension prédéfinie ($V_{MS}$), et un compteur (202) pour incrémenter et/ou décrémenter la valeur (A) du composant ajustable du premier couple en fonction d'un état de sortie du comparateur.

5.   Circuit électronique selon la revendication 4, dans lequel le compteur est initialisé à une valeur moyenne au début d'un étalonnage du composant variable.

6.   Circuit électronique selon la revendication 3, dans lequel le circuit d'étalonnage comporte :

- un registre de valeur (302) pour mémoriser un mot binaire représentatif de la valeur variable du composant ajustable, ledit registre étant initialisé à zéro au début de l'étalonnage du composant ajustable,
- des moyens (303, 308-310) aptes à appliquer un bit à l'état « 1 » de manière successive du poids fort au poids faible sur le mot binaire,
- un comparateur (201) pour comparer la tension maximale du signal de sortie ($V_{OUTMAX}$) avec une tension prédéfinie ($V_{MS}$),
- des moyens (305-307) pour mémoriser ou non le bit à l'état « 1 » dans le registre de valeur (302) en fonction d'un état de sortie du comparateur.

7.   Circuit électronique selon l'une des revendications 1 à 6, comportant un convertisseur continu/continu, ledit convertisseur incluant les premier et deuxième couples de composants et le circuit d'étalonnage.

8.   Circuit électronique selon l'une des revendications 1 à 7, ledit circuit électronique étant réalisé en circuit intégré sur un substrat de silicium.

9.   Procédé d'étalonnage d'un premier couple de composants constitué d'une résistance (R) et d'un condensateur (C), et d'au moins un deuxième couple de composants constitué d'une résistance ($R_1$-$R_3$) réalisée simultanément et par le même procédé que la résistance du premier couple et d'un condensateur ($C'_1$, $C'_2$) réalisé simultanément et par le même procédé que le condensateur du premier couple,

la résistance du premier couple étant un composant ajustable, le condensateur du second couple étant un composant ajustable,

dans lequel on réalise l'ajustement du composant ajustable du premier couple afin de compenser l'erreur sur le produit de la résistance par la capacité dudit premier couple,

et dans lequel la valeur d'ajustement (A) du composant ajustable du premier couple est appliquée proportionnellement à la valeur du composant ajustable du deuxième couple par rapport à la valeur du composant ajustable du premier couple.

**10.** Procédé selon la revendication 9, dans lequel les composants ajustables (R, $C'_1$, $C'_2$) des premier et deuxième couples comportent chacun une partie fixe ($R_F$, $C_F$) et une partie variable ($R_V$, $C_V$), et dans lequel le rapport (b, c) entre la partie fixe et la partie variable d'un composant variable est le même pour les premier et deuxième couples.

**Patentansprüche**

**1.** Elektronische Schaltung, umfassend :

- ein erstes Bauelemente-Paar, gebildet durch einen Widerstand (R) und einen Kondensator (C), wobei der Widerstand das anpassbare Bauelement des ersten Paars ist, und
- wenigstens ein zweites Bauelemente-Paar, gebildet durch einen Widerstand ($R_1$-$R_3$), durch dasselbe Herstellungsverfahren und simultan mit dem Widerstand des ersten Paars realisiert, und einen Kondensator ($C'_1$, $C'_2$), durch dasselbe Herstellungsverfahren und simultan mit dem Kondensator des ersten Paars realisiert, wobei der Kondensator das anpassbare Bauelement des zweiten Paars ist,
- eine Abgleichschaltung (106), um einen Anpassungswert des anpassbaren Bauelements (R) des ersten Paars zu erzeugen, um den Fehler bei dem Produkt aus Widerstand mal Kapazität des ersten Paars zu kompensieren, wobei der Anpassungswert des anpassbaren Bauelements des ersten Paars außerdem proportional zu dem Wert des anpassbaren Bauelements des zweiten Paars in Bezug auf den Wert des anpassbaren Bauelements des ersten Paars anwendbar ist.

**2.** Elektronische Schaltung nach Anspruch 1, bei der die anpassbaren Bauelemente (R, $C'_1$, $C'_2$) des ersten und des zweiten Paars jeweils einen fixen Teil ($R_F$, $C_F$) und einen variablen Teil $R_V$, $C_V$) umfassen, und bei dem das Verhältnis (b, c) zwischen dem fixen Teil und dem variablen Teil eines variablen Bauelements für das erste und das zweite Paare das gleiche ist.

**3.** Elektronische Schaltung nach einem der Ansprüche 1 bis 2, mit einem Rampengenerator (13), der das erste Bauelemente-Paar (R, C) umfasst und bei dem die Abgleichschaltung (106) den Wert des anpassbaren Bauelements (R) des ersten Paars anpasst in Abhängigkeit von dem Ausgangssignal des Rampengenerators (13).

**4.** Elektronische Schaltung nach Anspruch 3, bei der die Abgleichschaltung (106) einen Komparator (201) zum Vergleichen der maximalen Spannung des Ausgangssignals ($V_{OUTMAX}$) des Rampengenerators mit einer vordefinierten Spannung ($V_{MS}$) sowie einen Zähler (202) des anpassbaren Bauelements des ersten Paars umfasst, um den Wert (A) in Abhängigkeit von einem Ausgangszustand bzw. -status des Zählers zu inkrementieren und/oder zu dekrementieren.

**5.** Elektronische Schaltung nach Anspruch 4, bei der der Zähler zu Beginn eines Abgleichs des variablen Bauelements auf einen Mittelwert initialisiert wird.

**6.** Elektronische Schaltung nach Anspruch 3, bei der die Abgleichschaltung umfasst :

- ein Wertregister (302) zur Speicherung eines für den variablen Wert des anpassbaren Bauelements repräsentativen Binärworts, wobei das genannte Register zu Beginn des Abgleichs des anpassbaren Bauelements auf Null initialisiert wird,
- Einrichtungen (303, 308-310), fähig in sukzessiver Weise auf das Binärwort ein Bit mit Status "1" von höherwertig nach niedrigerwertig anzuwenden,
- einen Komparator (201), um die maximale Spannung des Ausgangssignals ($V_{OUTMAX}$) mit einer vordefinierten Spannung ($V_{MS}$) zu vergleichen,
- Einrichtungen (305-307), um das Bit mit dem Zustand "1" in Abhängigkeit von einem Ausgangsstatus des Komparators in das Wertregister (302) einzuspeichern oder nicht.

**7.** Elektronische Schaltung nach einem der Ansprüche 1 bis 6, umfassend einen DC/DC-Wandler, wobei der genannte Wandler das erste und das zweite Bauelemente-Paar und die Abgleichschaltung umfasst.

**8.** Elektronische Schaltung nach einem der Ansprüche 1 bis 7, wobei die genannte elektronische Schaltung als integrierte Schaltung auf einem Siliciumsubstrat realisiert wird.

**9.** Verfahren zum Abgleichen eines ersten Bauelemente-Paars, gebildet durch einen Widerstand (R) und einen Kondensator (C), und wenigstens eines zweiten Bauelemente-Paars, gebildet durch einen simultan und durch dasselbe Verfahren wie der Widerstand des ersten Paars realisierten Widerstand ($R_1$-$R_3$), und einen Kondensator ($C'_1$, $C'_2$), gebildet durch einen simultan und durch dasselbe Verfahren wie der Kondensator des ersten Paars realisierten Kondensator, wobei der Widerstand des ersten Paars ein anpassbares Bauelement ist, und der Kondensator des zweiten Paars ein anpassbares Bauelement ist,
bei dem man die Anpassung des anpassbaren Bauelements des ersten Paars realisiert, um den Fehler bei dem Produkt aus Widerstand mal Kapazität des genannten ersten Paars zu kompensieren,
und bei dem der Anpassungswert (A) des anpassbaren Bauelements des ersten Paars proportional zum Wert des anpassbaren Bauelements des zweiten Paars bezogen auf den Wert des anpassbaren Bauelements des ersten Paars angewendet wird.

**10.** Verfahren nach Anspruch 9, bei dem jedes der anpassbaren Bauelemente (F, $C'_1$, $C'_2$) des ersten und des zweiten Paars einen fixen Teil ($R_F$, $C_F$) und einen variablen Teil ($F_V$, $C_V$) umfasst, und bei dem das Verhältnis (b, c) zwischen dem fixen Teil und dem variablen Teil eines variablen Bauelements für das erste und das zweite Paar dasselbe ist.

**Claims**

**1.** Electronic circuit comprising:

- a first pair of components consisting of a resistor (R) and a capacitor (C), the resistor being the adjustable component of the first pair, and
- at least one second pair of components consisting of a resistor ($R_1$-$R_3$) made simultaneously and by the same manufacturing method as the resistor of the first pair and a capacitor ($C'_1$, $C'_2$) made simultaneously and by the same manufacturing method as the capacitor of the first pair, the capacitor being the adjustable component of the second pair,
- a calibration circuit (106) for producing an adjustment value of the adjustable component (R) of the first pair in order to compensate for the error on the product of the resistance by the capacitance of said first pair, the adjustment value of the adjustable component of the first pair being further applied proportionally to the value of the adjustable component of the second pair with respect to the value of the adjustable component of the first pair.

**2.** Electronic circuit according to claim 1, wherein the adjustable components (R, $C'_1$, $C'_2$) of the first and second pairs each comprise a fixed part ($R_F$, $C_F$) and a variable part ($R_V$, $C_V$), and wherein the ratio (b, c) between the fixed part and the variable part of a variable component is the same for the first and second pairs.

**3.** Electronic circuit according to any of claims 1 to 2, comprising a ramp generator (13) which includes the first pair of components (R, C) and wherein the calibration circuit (106) adjusts the value of the adjustable component (R) of the first pair according to the output signal of the ramp generator (13).

**4.** Electronic circuit according to claim 3, wherein the calibration circuit (106) comprises a comparator (201) for comparing the maximum voltage of the output signal ($V_{OUTMAX}$) of the ramp generator with a predetermined voltage ($V_{MS}$), and a counter (202) for incrementing and/or decrementing the value (A) of the adjustable component of the first pair according to an output state of the comparator.

**5.** Electronic circuit according to claim 4, wherein the counter is initialized to an average value at the beginning of a calibration of the variable component.

**6.** Electronic circuit according to claim 3, wherein the calibration circuit comprises:

- a value register (302) for storing a binary word representative of the variable value of the adjustable component, said register being initialized to zero at the beginning of the calibration of the adjustable component,
- means (303, 308-310) capable of applying a bit in the "1" state successively from the high order to the low order on the binary word,
- a comparator (201) for comparing the maximum voltage of the output signal ($V_{OUTMAX}$) with a predetermined voltage ($V_{MS}$),
- means (305-307) for storing or not the bit in the "1" state in the value register (302) according to an output state of the comparator.

7. Electronic circuit according to any of claims 1 to 6, comprising a DC/DC converter, said converter including the first and second pairs of components and the calibration circuit.

8. Electronic circuit according to any of claims 1 to 7, said electronic circuit being made as an integrated circuit on a silicon substrate.

9. Method of calibrating a first pair of components consisting of a resistor (R) and a capacitor (C), and at least a second pair of components consisting of a resistor ($R_1$-$R_3$) made simultaneously and by the same method as the resistor of the first pair and a capacitor ($C'_1$, $C'_2$) made simultaneously and by the same method as the capacitor of the first pair, the resistor of the first pair being an adjustable component, the capacitor of the second pair being an adjustable component,
wherein adjusting the adjustable component of the first pair is made to compensate for the error on the product of the resistance by the capacitance of said first pair,
and wherein the adjustment value (A) of the adjustable component of the first pair is applied proportionally to the value of the adjustable component of the second pair with respect to the value of the adjustable component of the first pair.

10. Method according to claim 9, wherein the adjustable components (R, $C'_1$, $C'_2$) of the first and second pairs each comprise a fixed part ($R_F$, $C_F$) and a variable part ($R_V$, $C_V$), and wherein the ratio (b, c) between the fixed part and the variable part of a variable component is the same for the first and second pairs.

FIG. 1

FIG. 2

FIG. 3

**FIG. 4**

**FIG. 5**

FIG. 6

FIG. 7

FIG. 8

FIG. 9

**EP 1 684 427 B1**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 5519265 A